(19) Europäisches Patentamt
European Patent Office
Office européen des brevets

(11) EP 1 588 992 A1

## (12) EUROPEAN PATENT APPLICATION

(43) Date of publication:
26.10.2005 Bulletin 2005/43

(51) Int Cl.⁷: **C04B 35/486**, C23C 14/08,
C23C 4/10, C23C 28/00

(21) Application number: 05250522.9

(22) Date of filing: 01.02.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 22.04.2004 US 830685

(71) Applicant: GENERAL ELECTRIC COMPANY
Schenectady, NY 12345 (US)

(72) Inventors:
• Gorman, Mark Daniel
West Chester, OH 45069 (US)
• Spitsberg, Irene
Loveland, OH 45140 (US)
• Boutwell, Brett Allen
Liberty Township, OH 45011 (US)
• Darolia, Ramgopal
West Chester, OH 45069 (US)
• Bruce, Robert William
Loveland, OJ 45140 (US)
• Venkataramani, Venkat Subramaniam
Clifton Park, NY 12065 (US)

(74) Representative: Pedder, James Cuthbert et al
London Patent Operation,
General Electric International, Inc.,
15 John Adam Street
London WC2N 6LU (GB)

(54) **Mixed metal oxide ceramic compositions for reduced conductivity thermal barrier coatings**

(57) Ceramic compositions comprising a main ceramic component comprising from 63 to 99 mole % zirconia and from 1 to 37 mole % hafnia. These compositions further comprise at least 4 mole % of a stabilizer metal oxide selected from the group consisting of yttria, calcia, ceria, scandia, magnesia, india, lanthana, gadolinia, neodymia, samaria, dysprosia, erbia, ytterbia, europia, praseodymia, and mixtures thereof. These ceramic compositions are useful in preparing thermal barrier coatings having reduced thermal conductivity for the substrate f articles that operate at, or are exposed to, high temperatures, as well as good producibility and impact/erosion resistance. Inclusion of hafnia also maintains the reduced conductivity of the thermal barrier coating after thermal exposure due to better sintering resistance.

EP 1 588 992 A1

**Description**

This invention relates to ceramic compositions for thermal barrier coatings comprising a mixture of zirconia and hafnia metal oxides for reduced thermal conductivity. This invention further relates to coatings prepared from such compositions, articles having such coatings and methods for preparing such coatings for the article.

Components operating in the gas path environment of gas turbine engines are typically subjected to significant temperature extremes and degradation by oxidizing and corrosive environments. Environmental coatings and especially thermal barrier coatings are an important element in current and future gas turbine engine designs, as well as other articles that are expected to operate at or be exposed to high temperatures, and thus cause the thermal barrier coating to be subjected to high surface temperatures. Examples of turbine engine parts and components for which such thermal barrier coatings are desirable include turbine blades and vanes, turbine shrouds, buckets, nozzles, combustion liners and deflectors, and the like. These thermal barrier coatings typically comprise the external portion or surface of these components and are usually deposited onto a metal substrate (or more typically onto a bond coat layer on the metal substrate for better adherence) from which the part or component is formed to reduce heat flow (i.e., provide thermal insulation) and to limit (reduce) the operating temperature the underlying metal substrate of these parts and components is subjected to. This metal substrate typically comprises a metal alloy such as a nickel, cobalt, and/or iron based alloy (e.g., a high temperature superalloy).

The thermal barrier coating is usually prepared from a ceramic material, such as a chemically (metal oxide) phase-stabilized zirconia. Examples of such chemically phase-stabilized zirconias include yttria-stabilized zirconia, scandia-stabilized zirconia, ceria-stabilized zirconia, calcia-stabilized zirconia, and magnesia-stabilized zirconia. The thermal barrier coating of choice is typically a yttria-stabilized zirconia ceramic coating. A representative yttria-stabilized zirconia thermal barrier coating usually comprises about 7 weight % yttria and about 93 weight % zirconia. The thickness of the thermal barrier coating depends upon the metal substrate part or component it is deposited on, but is usually in the range of from about 3 to about 70 mils (from about 76 to about 1788 microns) thick for high temperature gas turbine engine parts.

There are a variety of ways to further reduce the thermal conductivity of such thermal barrier coatings. One is to increase the thickness of the coating. However, thicker thermal barrier coatings suffer from weight and cost concerns. Another approach is to reduce the inherent thermal conductivity of the coating. One effective way to do this is to provide a layered structure such as is found in thermal sprayed coatings, e.g.,

air plasma spraying coatings. However, coatings formed by physical vapor deposition (PVD), such as electron beam physical vapor deposition (EB-PVD), that have a columnar structure are typically more suitable for turbine airfoil applications (e.g., blades and vanes) to provide strain tolerant, as well as erosion and impact resistant coatings.

Another general approach is to make compositional changes to the zirconia-containing ceramic composition used to form the thermal barrier coating. A variety of theories guide these approaches, such as: (1) alloying the zirconia lattice with other metal oxides to introduce phonon scattering defects, or at higher concentration levels, to provide very complex crystal structures; (2) providing "coloring agents" that absorb radiated energy; and (3) controlling the porosity and morphology of the coating. All of these approaches have limitations. For example, modifying the zirconia lattice, and in particular achieving a complex crystal structure, limits the potential options for chemical modification and can interfere with good spallation resistance and particle erosion resistance of the thermal barrier coating.

As noted earlier, thermal barrier coatings comprising yttria-stabilized zirconia that are formed by EB-PVD techniques have a columnar, strain-tolerant microstructure that enhances the spallation performance of the deposited coating. The resistance to heat flow through this coating structure is enhanced by the defect matrix in this structure created by the "dissolving" of yttria (the dopant oxide) into zirconia, as well as process-induced porosity.

This EB-PVD deposited yttria-stabilized coating provides a "feathery" microstructure that is the result of the presence of sub-grains within the columns of the coating.

When exposed to higher engine operating temperatures, this "feathery" microstructure begins to sinter. This sintering process also partially takes place during the deposition of the coating by EB-PVD. It has been found that this sintering occurs due to diffusion at the grain and sub-grain boundaries that is partially caused by the presence of defects in this microstructure. This results in coarsening and collapsing of the original porosity, as well as a reduction of the interface boundary area. These microstructural changes that occur at elevated temperatures increase the thermal conductivity of the thermal barrier coating, and thus reduce the thermal insulation of the underlying metal substrate. Indeed, this sintering process can increase the thermal conductivity of the thermal barrier coating by as much as 20 to 30%.

While this sintering process is particularly evident in EB-PVD deposited yttria-stabilized zirconia thermal barrier coatings, similar effects can occur in such coatings deposited by plasma spraying. In the case of plasma sprayed yttria-stabilized zirconia thermal barrier coatings, the splat boundaries are the primary conductivity reducing feature of such coatings. As a result, any sintering that would occur at such boundaries would be undesirable.

Accordingly, it would be desirable to minimize or reduce this sintering process so as to maintain the insulating efficacy of the thermal barrier coating for the life of the coating, especially with regard to coatings formed by EB-PVD techniques. It would be further desirable to be able to modify the chemical composition of yttria- stabilized zirconia-based thermal barrier coating systems to reduce this sintering tendency and thus maintain or improve the reduced thermal conductivity of such coatings. It would further be desirable to provide a balanced approach for ceramic compositions used to prepare thermal barrier coatings that reduce thermal conductivity, while at the same time achieving good producibility and good impact/erosion resistance.

An embodiment of this invention relates to ceramic compositions for preparing a thermal barrier coating for an underlying substrate of articles that operate at, or are exposed to, high temperatures. These compositions comprise:

> 1. a main ceramic component comprising from about 63 to about 99 mole % zirconia and from about 1 to about 37 mole % hafnia; and

> 2. at least about 4 mole % of a stabilizer metal oxide selected from the group consisting of yttria, calcia, ceria, scandia, magnesia, india, lanthana, gadolinia, neodymia, samaria, dysprosia, erbia, ytterbia, europia, praseodymia, and mixtures thereof.

Another embodiment of this invention relates to a thermally protected article. This protected article comprises:

> A. a substrate;

> B. optionally a bond coat layer adjacent to and overlaying the substrate; and

> C. a thermal barrier coating (prepared from the previously described ceramic composition) adjacent to and overlaying the bond coat layer (or overlaying the substrate if the bond coat layer is absent).

Another embodiment of this invention relates to a method for preparing the thermal barrier coating on a substrate to provide a thermally protected article. This method comprises the steps of:

> A. optionally forming a bond coat layer on the substrate; and

> B. depositing on the bond coat layer (or on the substrate in the absence of the bond coat layer) the ceramic composition previously described to form a thermal barrier coating.

The ceramic compositions of this invention provide several benefits in reducing the thermal conductivity of thermal barrier coatings used with substrates of articles exposed to high temperatures, such as turbine components. Inclusion of hafnia to replace zirconia in the ceramic composition lowers conductivity without impacting other desirable characteristics of the thermal barrier coating, such as impact and erosion resistance. Hafnia inclusion also results in a more "feathery" structure of the as-deposited thermal barrier coating that contributes to reduced conductivity thereof through increased porosity and reduced density. Inclusion of hafnia also maintains the reduced conductivity of the thermal barrier coating after thermal exposure due to better sintering resistance.

The invention will now be described in greater detail, by way of example, with reference to the drawings, in which:-

> 1 represents a plot of thermal conductivity as a function of deposition temperature of yttria-stabilized zirconias with various added levels of hafnia.

> FIG. 2 represents a plot of specific heat ($C_p$) versus molecular weight for various metal oxides, including hafnia.

> FIG. 3 represents a regression plot of conductivity versus specific heat for thermal barrier coatings prepared from various ceramic compositions, including those containing hafnia.

> FIG. 4 is a partial side sectional view of an embodiment of the thermal barrier coating and coated article of this invention.

As used herein, the term "thermal barrier coating" refers to those coatings that are capable of reducing heat flow to the underlying substrate of the article, i.e., forming a thermal barrier, and which have a melting point that is typically at least about 2600°F (1426°C), and more typically in the range of from about 3450° to about 4980°F (from about 1900° to about 2750°C).

As used herein, the term "comprising" means various compositions, compounds, components, layers, steps and the like can be conjointly employed in the present invention. Accordingly, the term "comprising" encompasses the more restrictive terms "consisting essentially of" and "consisting of."

All amounts, parts, ratios and percentages used herein are by mole % unless otherwise specified.

The ceramic compositions of this invention impart improved thermal conductivity properties to the resulting thermal barrier coatings, and in particular lower thermal conductivity. Thermal conductivity K is defined by the following equation (1):

$$K = \alpha \times (1-p) \times C_p \times D_t \qquad (1)$$

where $\alpha$ is the thermal diffusivity, p is the fraction of porosity, $C_p$ is the specific heat (in J/g*K), and $D_t$ is the theoretical density. As be seen from equation (1) above, thermal conductivity depends on thermal diffusivity and porosity.

The thermal barrier coating compositions of this invention comprise a main ceramic component, which typically comprises from about 60 to about 96% of the composition, more typically from about 80 to about 94.5% of the composition. The main ceramic component comprises from about 63 to about 99 mole % zirconia and from about 1 to about 37 mole % hafnia, typically as a substantially homogeneous blend or mixture. Usually, the main ceramic component of the compositions of this invention comprises from about 70 to about 98 mole % zirconia and from about 2 to about 30 mole % hafnia, typically from about 85 to about 98 mole % zirconia and from about 2 to about 15 mole % hafnia, more typically from about 90 to about 94 mole % zirconia and from about 6 to about 10 mole % hafnia.

The compositions of this invention further comprise at least about 4 mole % of a stabilizer metal oxide, or a mixture of stabilizer metal oxides. The particular amount of the stabilizer metal oxide(s) that is used will depend on a variety of factors, including the thermal insulating properties desired, the ability to minimize or reduce sintering of the resultant coating, the particular amounts and types of the stabilizer metal oxide(s) used and like factors. Typically, the stabilizer metal oxide(s) comprises from about 4 to about 40 mole %, more typically from about 5.5 to about 20 mole %, of the composition.

The stabilizer metal oxide can be selected from the group consisting of yttria, calcia, ceria, scandia, magnesia, india lanthana, gadolinia, neodymia, samaria, dysprosia, erbia, ytterbia, europia, praseodymia, and mixtures thereof. Typically, the stabilizer metal oxide is yttria and comprises from about 4 to about 9 mole %, more typically from about 4 to about 6 mole %, of the ceramic composition.

The ceramic compositions of this invention are based on the discovery that inclusion of hafnia as a partial replacement for zirconia in the main ceramic component provides an improved reduction in thermal conductivity of the resulting thermal barrier coating without other undesired effects. For example, inclusion of hafnia to partially replace zirconia in the ceramic composition lowers conductivity without impacting other desirable characteristics of the thermal barrier coating, such as impact and erosion resistance, because of two factors: (1) while hafnium is chemically indistinguishable from zirconium, it has a much higher mass that affects phonon scattering; and (2) hafnia inclusion reduces the specific heat of the thermal barrier coating more than would be predicted from its molecular weight.

Hafnia inclusion also reduces surface diffusion in the zirconia-containing thermal barrier coating structure during the deposition process, such as physical vapor deposition, used to prepare the thermal barrier coating, as well as during subsequent engine operation due to the lower diffusion rates of hafnia. This results in a more "feathery" structure of the as-deposited coating that contributes to reduced conductivity through increased porosity and reduced density. Inclusion of hafnia also maintains the reduced conductivity of the thermal barrier coating after thermal exposure due to better sintering resistance.

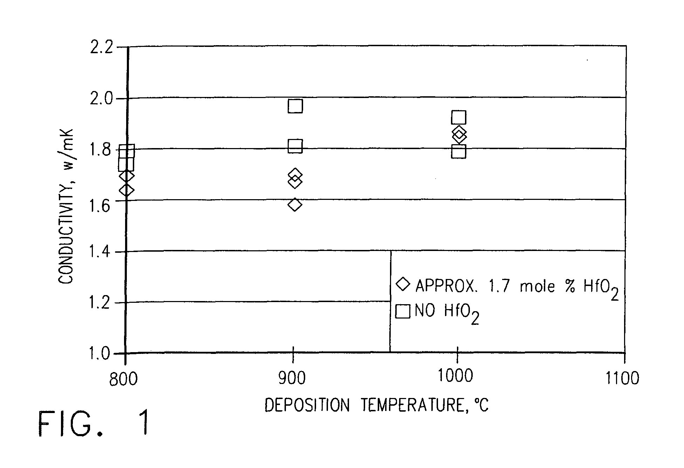

The benefits from the inclusion of hafnia as a partial replacement for zirconia on the thermal conductivity of the thermal barrier coatings prepared from these ceramic compositions is particularly shown in FIGs. 1-3. FIG. 1 represents a graph of thermal conductivity as a function of deposition temperature of yttria-stabilized zirconias with various levels (0 mole % and approximately 1.7 mole %) of hafnia added. As suggested by FIG. 1, inclusion of hafnia in yttria-stabilized zirconias reduces the thermal conductivity of zirconia-containing thermal barrier coatings.

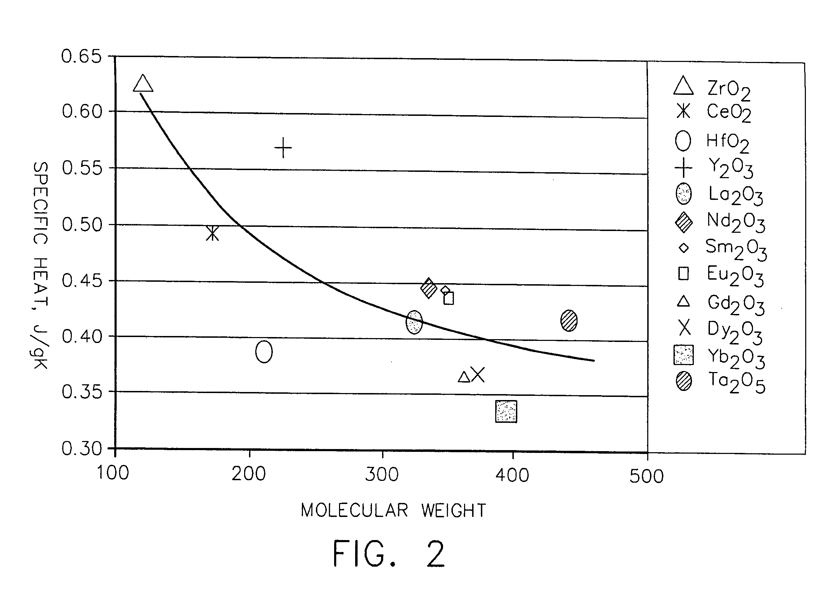

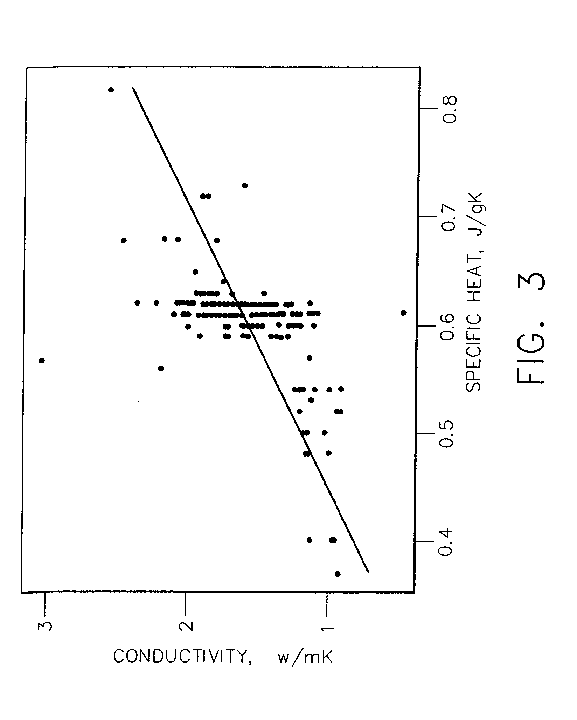

FIG. 2 represents a plot of specific heat (Cp) versus molecular weight of various metal oxide additions, including yttria, lanthana, ytterbia, hafnia and tantala. As shown in FIG. 2, several of the metal oxides, such as hafnia, fall below the specific heat trendline, and thus can provide desirable reductions in conductivity for zirconia-containing thermal barrier coatings beyond their expected effect on density. FIG. 3 represents a regression plot of conductivity versus specific heat for thermal barrier coatings prepared from various ceramic compositions. The results in FIG. 3 are consistent with equation (1) above and show the conductivity reduction achieved in zirconia-containing thermal barrier coatings by including other metal oxides, such as hafnia, which lower specific heat.

Thermal barrier coatings prepared from the ceramic compositions of this invention are useful with a wide variety of turbine engine (e.g., gas turbine engine) parts and components that are formed from substrates, typically metal substrates comprising a variety of metals and metal alloys, including superalloys, and are operated at, or exposed to, high temperatures, especially higher temperatures that occur during normal engine operation. These turbine engine parts and components can include turbine airfoils such as blades and vanes, turbine shrouds, turbine nozzles, combustor components such as liners and deflectors, augmentor hardware of gas turbine engines and the like. The thermal barrier coatings of this invention can also cover a portion or all of the metal substrate. For example, with regard to airfoils such as blades, the thermal barrier coatings of this invention are typically used to protect, cover or overlay portions of the metal substrate of the airfoil rather than the entire component, e.g., the thermal barrier coatings cover the leading and trailing edges and other surfaces of the airfoil, but not the attachment area. While the following discussion of the thermal barrier coatings of this invention will be with reference to metal substrates of turbine engine parts and components, it should also be understood that the thermal barrier coatings of this invention are useful with metal substrates of other articles that operate at, or are exposed to, high temperatures.

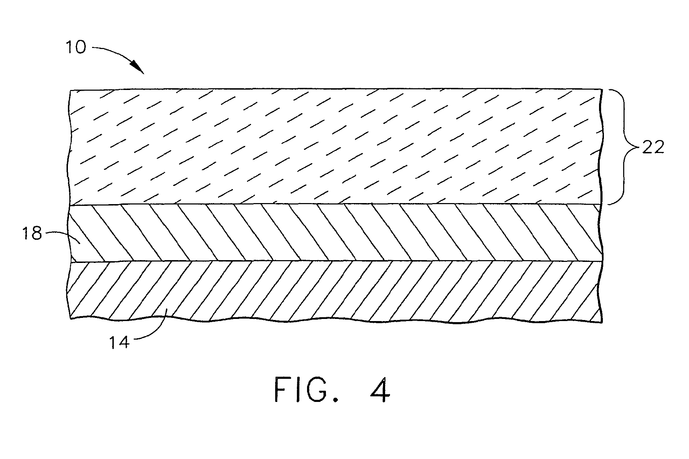

The various embodiments of the thermal barrier coatings of this invention are further illustrated by reference to the drawings as described hereafter. Referring to the drawings, FIG. 4 shows a partial side sectional view of an embodiment of the thermal barrier coating used with the metal substrate of an article indicated generally as 10. As shown in FIG. 4, article 10 has a metal substrate indicated generally as 14. Substrate 14 can comprise any of a variety of metals, or more typically metal alloys, that are typically protected by thermal barrier coatings, including those based on nickel, cobalt and/or iron alloys. For example, substrate 14 can comprise a high temperature, heat-resistant alloy, e.g., a superalloy. Such high temperature alloys are disclosed in various references, such as U.S. Pat. No. 5,399,313 (Ross et al), issued March 21, 1995 and U.S. Pat. No. 4,116,723 (Gell et al), issued September 26, 1978, both of which are incorporated by reference. High temperature alloys are also generally described in Kirk-Othmer's Encyclopedia of Chemical Technology, 3rd Ed., Vol. 12, pp. 417-479 (1980), and Vol. 15, pp. 787-800 (1981). Illustrative high temperature nickel-based alloys are designated by the trade names Inconel®, Nimonic®, Rene@ (e.g., Rene® 80, Rene® N5 alloys), and Udimet®. As described above, the type of substrate 14 can vary widely, but it is representatively in the form of a turbine part or component, such as an airfoil (e.g., blade) or turbine shroud.

As shown in FIG. 4, article 10 can also include a bond coat layer indicated generally as 18 that is adjacent to and overlies substrate 14. Bond coat layer 18 is typically formed from a metallic oxidation-resistant material that protects the underlying substrate 14 and enables the thermal barrier coating indicated generally as 22 to more tenaciously adhere to substrate 14. Suitable materials for bond coat layer 18 include MCrAlY alloy powders, where M represents a metal such as iron, nickel, platinum or cobalt, or NiAl(Zr) compositions, as well as various noble metal diffusion aluminides such as platinum aluminide, as well as simple aluminides (i.e., those formed without noble metals). This bond coat layer 18 can be applied, deposited or otherwise formed on substrate 10 by any of a variety of conventional techniques, such as physical vapor deposition (PVD), including electron beam physical vapor deposition (EB-PVD), plasma spray, including air plasma spray (APS) and vacuum plasma spray (VPS), or other thermal spray deposition methods such as high velocity oxy-fuel (HVOF) spray, detonation, or wire spray, chemical vapor deposition (CVD), pack cementation and vapor phase aluminiding in the case of metal diffusion aluminides (see, for example, U.S. Pat. No. 4,148,275 (Benden et al), issued April 10, 1979; U.S. Pat. No. 5,928,725 (Howard et al), issued July 27, 1999; and U.S. Pat. No. 6,039,810 (Mantkowski et al), issued March 21, 2000, all of which are incorporated by reference and which disclose various apparatus and methods for applying diffusion aluminide coatings, or combinations of such techniques, such as, for example, a combination of plasma spray and diffusion aluminide techniques. Typically, plasma spray or diffusion techniques are employed to deposit bond coat layer 18. Usually, the deposited bond coat layer 18 has a thickness in the range of from about 1 to about 20 mils (from about 25 to about 508 microns). For bond coat layers 18 deposited by PVD techniques such as EB-PVD or diffusion aluminide processes, the thickness is more typically in the range of from about 1 about 4 mils (from about 25 to about 102 microns). For bond coat layers deposited by plasma spray techniques such as APS, the thickness is more typically in the range of from about 3 to about 15 mils (from about 76 to about 381 microns).

As shown in FIG. 4, thermal barrier coating (TBC) 22 prepared from the ceramic composition of this invention is adjacent to and overlies bond coat layer 18. The thickness of TBC 22 is typically in the range of from about 1 to about 100 mils (from about 25 to about 2540 microns) and will depend upon a variety of factors, including the article 10 that is involved. For example, for turbine shrouds, TBC 22 is typically thicker and is usually in the range of from about 30 to about 70 mils (from about 762 to about 1778 microns), more typically from about 40 to about 60 mils (from about 1016 to about 1524 microns). By contrast, in the case of turbine blades, TBC 22 is typically thinner and is usually in the range of from about 1 to about 30 mils (from about 25 to about 762 microns), more typically from about 3 to about 20 mils (from about 76 to about 508 microns).

In forming TBCs 22, the ceramic compositions of this invention can be applied, deposited or otherwise formed on bond coat layer 18 by any of a variety of conventional techniques, such as physical vapor deposition (PVD), including electron beam physical vapor deposition (EB-PVD), plasma spray, including air plasma spray (APS) and vacuum plasma spray (VPS), or other thermal spray deposition methods such as high velocity oxy-fuel (HVOF) spray, detonation, or wire spray, chemical vapor deposition (CVD), or combinations of plasma spray and CVD techniques. The particular technique used for applying, depositing or otherwise forming TBC 22 will typically depend on the composition of TBC 22, its thickness and especially the physical structure desired for TBC 22. For example, PVD techniques tend to be useful in forming TBCs having a strain-tolerant columnar structure. By contrast, plasma spray techniques (e.g., APS) tend to create a splat-layered porous structure. TBC 22 is typically formed from ceramic compositions of this invention by PVD, and especially EB-PVD techniques to provide a strain-tolerant columnar structure.

Various types of PVD and especially EB-PVD techniques well known to those skilled in the art can also be utilized to form TBCs 22 from the ceramic compositions of this invention. See, for example, U.S. Pat. No. 5,645,893 (Rickerby et al), issued July 8, 1997 (especially col. 3, lines 36-63); U.S. Pat. No. 5,716,720 (Murphy), issued February 10, 1998) (especially col. 5, lines 24-61); and U.S. Pat. No. 6,447,854 (Rigney et al), issued September 10, 2002, which are all incorporated by reference. Suitable EB-PVD techniques for use herein typically involve a coating chamber with a gas (or gas mixture) that preferably includes oxygen and an inert gas, though an oxygen-free coating atmosphere can also be employed. The ceramic coating compositions are then evaporated with an electron beam focused on, for example, ingots of the ceramic coating compositions so as to produce a vapor of metal ions, oxygen ions and one or more metal oxides. The metal and oxygen ions and metal oxides recombine to form TBC 22 on the surface of metal substrate 14, or more typically on bond coat layer 18.

Various types of plasma-spray techniques well known to those skilled in the art can also be utilized to form TBCs 22 from the ceramic compositions of this invention. See, for example, Kirk-Othmer Encyclopedia of Chemical Technology, 3rd Ed., Vol. 15, page 255, and references noted therein, as well as U.S. Pat. No. 5,332,598 (Kawasaki et al), issued July 26, 1994; U.S. Pat. No. 5,047,612 (Savkar et al) issued September 10, 1991; and U.S. Pat. No. 4,741,286 (Itoh et al), issued May 3, 1998 (herein incorporated by reference) which are instructive in regard to various aspects of plasma spraying suitable for use herein. In general, typical plasma spray techniques involve the formation of a high-temperature plasma, which produces a thermal plume. The ceramic coating composition (e.g., ceramic powders) are fed into the plume, and the high-velocity plume is directed toward the bond coat layer 18. Various details of such plasma spray coating techniques will be well-known to those skilled in the art, including various relevant steps and process parameters such as cleaning of the bond coat surface 18 prior to deposition; grit blasting to remove oxides and roughen the surface, substrate temperatures, plasma spray parameters such as spray distances (gun-to-substrate), selection of the number of spray-passes, powder feed rates, particle velocity, torch power, plasma gas selection, oxidation control to adjust oxide stoichiometry, angle-of-deposition, post-treatment of the applied coating; and the like. Torch power can vary in the range of about 10 kilowatts to about 200 kilowatts, and in preferred embodiments, ranges from about 40 kilowatts to about 60 kilowatts. The velocity of the ceramic coating composition particles flowing into the plasma plume (or plasma "jet") is another parameter which is usually controlled very closely.

Suitable plasma spray systems are described in, for example, U.S. Pat. No.5,047,612 (Savkar et al) issued September 10, 1991, which is incorporated by reference. Briefly, a typical plasma spray system includes a plasma gun anode which has a nozzle pointed in the direction of the deposit-surface of the substrate being coated. The plasma gun is often controlled automatically, e.g., by a robotic mechanism, which is capable of moving the gun in various patterns across the substrate surface. The plasma plume extends in an axial direction between the exit of the plasma gun anode and the substrate surface. Some sort of powder injection means is disposed at a predetermined, desired axial location between the anode and the substrate surface. In some embodiments of such systems, the powder injection means is spaced apart in a radial sense from the plasma plume region, and an injector tube for the powder material is situated in a position so that it can direct the powder into the plasma plume at a desired angle. The powder particles, entrained in a carrier gas, are propelled through the injector and into the plasma plume. The particles are then heated in the plasma and propelled toward the substrate. The particles melt, impact on the substrate, and quickly cool to form the thermal barrier coating.

EXAMPLES

The following illustrates embodiments of thermal barrier coatings of this invention:

Example 1. A thermal barrier coating is prepared from the following ceramic composition:

Table 1

| Metal Oxide | Mole % | Wt. % |
|---|---|---|
| Zirconia | 94.0 | 91.4 |
| Yttria | 4.0 | 7.0 |
| Hafnia | 2.0 | 3.3 |

Example 2. A thermal barrier coating is prepared from the following ceramic composition:

Table 2

| Metal Oxide | Mole % | Wt. % |
|---|---|---|
| Zirconia | 74.0 | 62.1 |
| Yttria | 6.0 | 9.2 |
| Hafnia | 20.0 | 29.7 |

Example 3. A thermal barrier coating is prepared from the following ceramic composition:

Table 3

| Metal Oxide | Mole % | Wt. % |
|---|---|---|
| Zirconia | 81.0 | 61.4 |

Table 3 (continued)

| Metal Oxide | Mole % | Wt. % |
|---|---|---|
| Yttria | 1.3 | 1.8 |
| Ytterbia | 12.2 | 29.5 |
| Hafnia | 5.6 | 7.3 |

Example 4. A thermal barrier coating is prepared from the following ceramic composition:

Table 4

| Metal Oxide | Mole % | Wt. % |
|---|---|---|
| Zirconia | 60.1 | 36.5 |
| Yttria | 0.5 | 0.6 |
| Neodymia | 35.3 | 58.5 |
| Hafnia | 4.1 | 4.2 |

Example 5. A thermal barrier coating is prepared from the following ceramic composition:

Table 5

| Metal Oxide | Mole % | Wt. % |
|---|---|---|
| Zirconia | 72.4 | 49.1 |
| Yttria | 0.8 | 1.0 |
| Ytterbia | 18.8 | 40.8 |
| Hafnia | 7.9 | 9.2 |

**Claims**

1. A ceramic composition, which comprises:

   1; a main ceramic component comprising from about 63 to about 99 mole % zirconia and from 1 to 37 mole % hafnia; and
   2. at least 4 mole % of a stabilizer metal oxide selected from the group consisting of yttria, calcia, ceria, scandia, magnesia, india, lanthana, gadolinia, neodymia, samaria, dysprosia, erbia, ytterbia, europia, praseodymia, and mixtures thereof.

2. The composition of claim 1 wherein the main ceramic component comprises from 70 to 98 mole % zirconia and from 2 to 30 mole % hafnia.

3. The composition of any of claims 1 to 2 which comprises from 60 to 96% main ceramic component and from 4 to 40 mole % stabilizer component.

4. The composition of any of claims 1 to 3 wherein the main ceramic component comprises a substantially homogeneous blend of zirconia and hafnia.

5. The composition of any of claims 1 to 4 wherein the stabilizer metal oxide is yttria.

6. The composition of claim 5 which comprises from 4 to 9 mole % yttria.

7. A thermally protected article (10), which comprises:

   A. a substrate (14);
   B. a bond coat layer (18) adjacent to and overlaying the metal substrate (14) and
   C. the thermal barrier coating (22) of any of claims 1 to 6 adjacent to and overlaying the bond coat layer (18).

8. The article (10) of claim 7 wherein the substrate (14) is a metal substrate and wherein the thermal barrier coating (22) has a thickness of from 25 to 2540 microns.

9. The article (10) of any of claims 7 to 8 wherein the thermal barrier coating (22) has a strain-tolerant columnar structure.

10. A method for preparing a thermal barrier coating (22) on a bond coat layer (18) adjacent to and overlaying a metal substrate (14), the method comprising the steps of:

    forming a thermal barrier coating (22) on the bond coat layer (18) by depositing a ceramic composition, which comprises:

    1. a main ceramic component comprising from 63 to 99 mole % zirconia and from 1 to 37 mole % hafnia; and
    2. a stabilizing amount of a stabilizer metal oxide selected from the group consisting of yttria, calcia, ceria, scandia, magnesia, india, lanthana, gadolinia, neodymia, samaria, dysprosia, erbia, ytterbia, europia, praseodymia, and mixtures thereof.

11. The method of claim 10 wherein the ceramic composition is deposited by physical vapor deposition to form a thermal barrier coating (22) having a strain-tolerant columnar structure.

FIG. 1

FIG. 2

FIG. 3

FIG. 4

**EP 1 588 992 A1**

European Patent Office

# EUROPEAN SEARCH REPORT

Application Number

EP 05 25 0522

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/118873 A1 (MURPHY KENNETH S) 26 June 2003 (2003-06-26) * paragraph [0011] - paragraph [0012]; figure 3; examples * ----- | 1-11 | C04B35/486 C23C14/08 C23C4/10 C23C28/00 |
| X | US 2003/180571 A1 (SINGH JOGENDER) 25 September 2003 (2003-09-25) * paragraph [0091] - paragraph [0092] * ----- | 1-11 | |
| X | US 6 044 830 A (JONES ET AL) 4 April 2000 (2000-04-04) table 1, examples 1-2 to 1-7 ----- | 1,3-5 | |
| X | IBAGAZENE H ET AL: "Yttria-stabilized hafnia-zirconia thermal barrier coatings: the influence of hafnia addition on TBC structure and high-temperature behaviour" JOURNAL OF MATERIALS SCIENCE, CHAPMAN AND HALL LTD. LONDON, GB, vol. 30, no. 4, 15 February 1995 (1995-02-15), pages 938-951, XP002236919 ISSN: 0022-2461 * the whole document * ----- | 1-11 | |
| X | US 5 894 053 A (FRIED ET AL) 13 April 1999 (1999-04-13) * column 4, line 16 - line 21 * ----- | 1-11 | TECHNICAL FIELDS SEARCHED (Int.Cl.7) C04B C23C |
| P,X | GB 2 398 799 A (* JAPAN FINE CERAMICS CENTER; * ISHIKAWAJIMA-HARIMA HEAVY INDUSTRIES C) 1 September 2004 (2004-09-01) whole document, but in particular examples 2-4 ----- | 1-11 | |
| E | US 6 858 334 B1 (GORMAN MARK DANIEL ET AL) 22 February 2005 (2005-02-22) * table 2 * ----- | 1-11 | |

The present search report has been drawn up for all claims

| Place of search | Date of completion of the search | Examiner |
|---|---|---|
| Munich | 15 March 2005 | Munro, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 05 25 0522

This annex lists the patent family members relating to the patent documents cited in  the above-mentioned European search report.
The members are as contained in the European Patent Office EDP file on
The European Patent Office is in no way liable for these particulars which are merely  given for the purpose of information.

15-03-2005

| Patent document cited in search report | | Publication date | Patent family member(s) | | Publication date |
|---|---|---|---|---|---|
| US 2003118873 | A1 | 26-06-2003 | CA | 2412455 A1 | 21-06-2003 |
| | | | DE | 10254210 A1 | 11-09-2003 |
| | | | FR | 2833972 A1 | 27-06-2003 |
| | | | GB | 2383339 A ,B | 25-06-2003 |
| | | | JP | 2003201803 A | 18-07-2003 |
| US 2003180571 | A1 | 25-09-2003 | US | 2002110698 A1 | 15-08-2002 |
| | | | AU | 1959501 A | 25-06-2001 |
| | | | WO | 0143965 A1 | 21-06-2001 |
| US 6044830 | A | 04-04-2000 | US | 5780178 A | 14-07-1998 |
| | | | US | 5939147 A | 17-08-1999 |
| US 5894053 | A | 13-04-1999 | DE | 19545025 A1 | 05-06-1997 |
| | | | AT | 211185 T | 15-01-2002 |
| | | | CA | 2188614 A1 | 03-06-1997 |
| | | | CN | 1160088 A | 24-09-1997 |
| | | | CZ | 9603468 A3 | 13-08-1997 |
| | | | DE | 59608498 D1 | 31-01-2002 |
| | | | EP | 0776985 A1 | 04-06-1997 |
| | | | JP | 9176818 A | 08-07-1997 |
| | | | PL | 317298 A1 | 09-06-1997 |
| | | | PL | 182552 B1 | 31-01-2002 |
| | | | RU | 2209256 C2 | 27-07-2003 |
| GB 2398799 | A | 01-09-2004 | JP | 2004270032 A | 30-09-2004 |
| US 6858334 | B1 | 22-02-2005 | NONE | | |

EPO FORM P0459

For more details about this annex : see Official Journal of the  European Patent Office, No. 12/82